# EUROPEAN PATENT APPLICATION

(11) **EP 4 632 789 A1**
(43) Date of publication of application: **15.10.2025**
(21) Application number: 24169351.4
(22) Date of filing: 10.04.2024
(51) Int. Cl.: H01J 37/244, H01J 37/22, H01J 37/26, H01J 37/28

(54) **CHARGED PARTICLE MICROSCOPE HAVING A CHARGED PARTICLE DETECTOR**

(71) Applicant: FEI COMPANY, Hillsboro, OR 97124 (US)
(72) Inventor: FRANKEN, Erik, Nuenen (NL); VARSLOT, Trond, Vuku (NO); JANSSEN, Bart, Lent (NL)
(74) Representative: Janssen, Francis-Paul

(57) **Abstract**

A charged particle microscope that incorporates dual data stream output interfaces within its imaging system. These interfaces enable the microscope to capture and process data from the charged particle camera in two distinct ways, leading to enhanced imaging capabilities and improved flexibility. This invention has the potential to significantly advance the field of charged particle microscopy and find applications in various scientific and industrial settings.

## Description

The present invention relates to a charged particle microscope for imaging samples. More specifically, it pertains to a system that utilizes a charged particle optical column, a sample holder, a charged particle camera, and an imaging system to generate detailed images of samples.

In various scientific and industrial applications, it is often necessary to examine the microscopic structure and composition of samples. Traditional optical microscopes have limitations in resolution and are unable to provide sufficient detail for certain types of samples. To overcome these limitations, charged particle microscopes have been developed.

Charged particle microscopy is a well-known and increasingly important technique for imaging microscopic objects, particularly in the form of electron microscopy. Historically, the basic genus of electron microscope has undergone evolution into a number of well-known apparatus species, such as the Transmission Electron Microscope (TEM), Scanning Electron Microscope (SEM), and Scanning Transmission Electron Microscope (STEM), and also into various sub-species, such as a so-called "dual-beam" apparatus (e.g. a FIB-SEM) that additionally employs a Focused Ion Beam (FIB), allowing supportive activities such as ion-beam milling or lon-Beam-Induced Deposition (IBID). The skilled person will be familiar with the different species of charged particle microscopy.

These charged particle microscopes generally comprise several components, which will be explained below.

Firstly, a charged particle microscope comprises a charged particle optical column that is employed to direct a charged particle beam onto the sample. This optical column is responsible for directing and controlling the charged particles to the sample to ensure accurate imaging.

Additionally, the charged particle microscope comprises a sample holder for securely holding a sample in place during the imaging process. The sample holder is generally designed to accommodate various sample sizes and shapes, providing stability and reproducibility in positioning.

Furthermore, the charged particle microscope comprises a charged particle camera to capture charged particles that interact with the sample. The charged particle camera converts the energy or intensity of the charged particles into electrical signals, which can be further processed for image generation.

The charged particle microscope also includes an imaging system that is arranged for processing signals from the charged particle camera. The imaging system receives data from the charged particle camera and generates an image signal based on the collected information.

The charged particle microscope includes a charged particle camera output interface, which enables output of a data stream related to the charged particle camera. In current imaging systems, specifically those incorporating Transmission Electron Microscope (TEM) cameras, the output interface is designed to provide the best image quality, with a focus on high reliability of data, and ensuring minimal data loss.

In the realm of charged particle microscopes, particularly in Transmission Electron Microscopy (TEM), there still exists a significant challenge in certain applications, including active image-based drift compensation, continuous tilt tomography field-of-view correction, and system state measurement methods. Current systems exhibit limitations, especially in the context of electron counting cameras where the electron counting algorithm plays a pivotal role.

Thus, there is a desire for a system and a method to effectively support these applications without compromising the overall performance of the imaging systems.

It is therefore an objective of the present disclosure to provide an improved charged particle microscope and/or improved method. In particular it is an objective of the present disclosure to provide a charged particle microscope that allows real-time feedback without compromising reliability of data and whilst ensuring minimal data loss.

To this end, the disclosure provides a charged particle microscope as defined in claim 1. The charged particle microscope as disclosed herein comprises a charged particle optical column. The column is arranged for directing a charged particle beam, such as an electron beam or an ion beam, onto a sample. The system also has a sample holder for holding a sample. The system includes a charged particle camera and an imaging system. The imaging system generates an image signal based on information from the detectorcamera. The imaging system has a first output interface. This interface outputs a first data stream of data related to the camera.

As defined herein, the charged particle microscope further comprises a second charged particle camera output interface for outputting a second data stream of data related to said charged particle camera. In this sense, the charged particle microscope and both said first and second charged particle camera output interfaces are arranged in such a way that said second data stream is different compared to said first data stream.

In accordance with the present invention, the disclosed charged particle microscope provides an effective and innovative solution to the problem of providing real-time feedback while maintaining high data quality and reliability. By having two charged particle camera output interfaces that are arranged for providing different data steams compared to each other, the system allows to have two separate data streams that can be used for different purposes.

As an example, the first data stream may be designed to prioritize data quality and reliability, ensuring accurate and dependable data output (i.e. maintaining the high image quality standard that present day charged particle microscopes are known for).

The second data stream may be designed to be optimized for low latency and/or fixed latency, thus enabling one or more key parameters for real-time feedback to the charged particle system. The inclusion of this second output interface, and the distinct arrangement of the second data stream from the first data stream, allows for real-time feedback that is desired (or even required) for certain applications, such as active image-based drift compensation, continuous tilt tomography field-of-view correction, or system state measurement methods. The dual output interface design of the charged particle microscope thus ensures both 1) high data quality and reliability; and 2) the provision of real-time feedback, striking a balance that was not achievable with previous systems.

As defined herein, latency relates to the time difference between the moment a charged particle hits the charged particle camera and the moment the information from that charged particle is ready to be used by any device that is positioned downstream of the output interface. An example of such a device that is/can be positioned downstream of the output interface, is given by a data storage, a feedback processing device, a controller, etcetera. Latency can relate to the average time difference or the maximum time difference.

In an embodiment that is suitable for charged particle microscopy, the latency is in the order of half the readout integration time of the charged particle camera. If the charged particle camera, which can be a TEM camera, for example, runs at 500 fps, every pixel readout takes 2 ms. Low latency means that the time it takes for the data to come from the charged particle camera and be output through said second output interface (after which it can be used by a further processing device, for example) is in the order of the pixel readout too. This means that the low latency should be in the order of ms. Based on this example, the average latency should be in the order of 1 ms, and the maximum latency should be in the order of 2 ms. Note that a maximum latency of 6 ms still provides excellent results.

Thus, the low latency can be related to the frame rate of the charged particle camera, and the average low latency may be in the order of half the readout integration time, and the maximum latency may be in the order of the readout integration time.

In summary, the present disclosure describes a charged particle microscope with a dual output data interface that can be used for different data streams: one that is optimized, for example, for low latency, thereby enhancing the efficiency of real-time charged particle microscopes infrastructure; and one that is optimized for high quality, reliable data, thereby maintaining the high image quality of the charged particle microscopes. With this, the object of the disclosure is achieved.

Further embodiments will be elucidated below.

In an embodiment, the charged particle microscope is arranged in such a way that the second data stream is optimized for low latency output.

Such a low latency output may be defined by having a maximum low latency output of 750 ms, in particular having a maximum low latency output of 250 ms. In an example, the system is designed to have an average latency (delay) in the order of 10⁰ to 10¹ ms, such as 1 to 50 ms, and preferable in the range of 2 to 8 ms.

As indicated above, the maximum low latency output can be related to the frame rate of the charged particle camera. For a frame rate of 500 fps, the maximum low latency is preferably in the order of 1/500 = 2 ms. For a lower frame rate (e.g. 250 fps) the maximum low latency can be 1/250 = 4 ms. A higher latency (such as 10 times higher, thus in the order of 10 ms, or even in the order of 100 ms) may still be used to produce acceptable results.

Additionally, or alternatively, the charged particle microscope is arranged in such a way that the second data stream has a substantially fixed low latency output. Such a fixed low latency output may have an average latency output that is below 100 ms. In an example, the system is designed to have a fixed latency (delay) in the order of 10⁰ to 10¹ ms, such as 1 to 50 ms, and preferably in the range of 2 to 8 ms.

In an embodiment, the charged particle microscope is arranged in such a way that the second data stream has an average low latency output being below 100 ms and having a maximum low latency output of 750 ms, preferably of 250 ms or less.

As indicated above, the average low latency output can be related to the frame rate of the charged particle camera. For a frame rate of 500 fps, the average low latency is preferably in the order of 0.5*1/500 = 1 ms. For a lower frame rate (e.g. 250 fps) the average low latency can be 0.5*1/250 = 2 ms.

The charged particle microscope may be arranged in such a way that the second data stream is arranged to have a lower latency output compared to the first data stream. The latency of the second data stream may be at least one order smaller compared to the latency of the first data stream. In an example, the latency of the second data stream is two orders smaller compared to the latency of the first data stream. In an example, the latency of storing high quality data using the first data stream can be up to a couple of seconds (i.e. in the order of 10³ ms) and the latency of the low latency second data stream can be up to a tens of microseconds (i.e. in the order of 10¹ ms), or even less.

In an embodiment, the charged particle microscope is arranged such that the charged particle microscope and the second charged particle camera output data interface are connected and arranged to utilize the image signal from the imaging system for providing real-time feedback to the charged particle microscope. This is particularly useful in case the second charged particle camera output is arranged for providing low latency and/or fixed latency output, as described above. This low latency and/or fixed latency output allows real-time feedback loops to be established, which can be beneficial in applications such as active image-based drift compensation, continuous tilt tomography field-of-view correction, or system state measurement methods. Other applications of real-time feedback loops as described herein are conceivable as well.

In an embodiment, the first data stream is arranged to be optimized for high reliability, which may include, in a further embodiment, that the first data stream is optimized for complete data transfer without substantial data loss. This means that data is transferred without corrupt information packets. In an embodiment, it is possible that the checksum of the data packet indicates transmission errors. The charged particle microscope and/or the imaging system can be arranged in such a way that any indication of transmission errors will cause the receiving side to request resending the information packet. For the second data stream, whenever low latency is required, the charged particle microscope and/or the imaging system can be arranged in such a way that the data stream is marked as "bad" whenever transmission errors are indicated, but this would not lead to any retransmission of the data to prevent latency built-up/variations.

In an embodiment, the charged particle microscope comprises a data processing unit that is positioned upstream of said first and second charged particle camera output interfaces. The data processing unit is arranged to process, in a first step, raw data coming from the charged particle camera chip, before sending it to the camera output interfaces. Said data processing unit may be an FPGA, ASIC and/or a GPU that is part of the charged particle camera, for example. Thus, said charged particle camera may comprise a charged particle camera chip, that is connected to the data processing unit downstream of said charged particle camera chip. The data processing unit is connected to the second charged particle camera output interface, that is provided downstream of said data processing unit.

The data processing unit may be a piece of processing hardware that is included inside the charged particle camera, such as a TEM camera, and may be an integral part thereof. The data processing unit can comprise one or more of an FPGAs, a GPUs, or a CPU. The data processing unit can be arranged for running processing algorithms on raw data coming from the sensor chip.

The data processing unit may be arranged for processing data that is provided to said second charged particle camera output interface.

The data processing unit may additionally or alternatively be arranged for processing data that is provided to said second charged particle camera output interface.

The first charged particle camera output may be arranged for outputting said data coming from the data processing unit. The system may be arranged for storing data coming from the charged particle camera, and being processed by the data processing unit, on a storage server system that is connected to said charged particle microscope by means of said first charged particle camera output. The data stored on said storage server system can then be post-processed, e.g. after an experiment of imaging a sample is completed.

In an embodiment, the charged particle microscope includes a feedback data processing device that is positioned downstream of said second charged particle camera output interface. With this the data coming from the second output data interface can be processed in order to be used as feedback data to the charged particle microscope. This way, the second output data interface may include additional processing steps as well as data augmentation steps based on other information sources such as system clocks.

In an embodiment, the charged particle camera is a charged particle camera, such as a TEM camera, that is arranged for obtaining images from a sample. The TEM camera may work in so-called integration mode. In another embodiment, the TEM camera may work in electron counting mode. For Integration-mode cameras direct detection may be used, for indirect detection a scintillator layer may be used to convert electrons to photons, and the camera detects photons. Counting camera's can produce "counted frames" or EER data. Electron counting is an exmple of a low-level processing pipeline component that slightly increases latency.

### Brief description of the drawings

For a more thorough understanding of the present disclosure, and advantages thereof, reference is now made to the following descriptions taken in conjunction with the accompanying drawings, in which:
Fig. 1 shows a longitudinal cross-sectional view of a charged particle microscope, in particular a transmission charged particle microscope;
Fig. 2 shows a longitudinal cross-sectional view of a charged particle microscope, in particular a scanning charged particle microscope;
Fig. 3 shows an embodiment of a charged particle microscope having an imaging system as defined herein;
Fig. 4 shows a further embodiment of a charged particle microscope having an imaging system as defined herein;

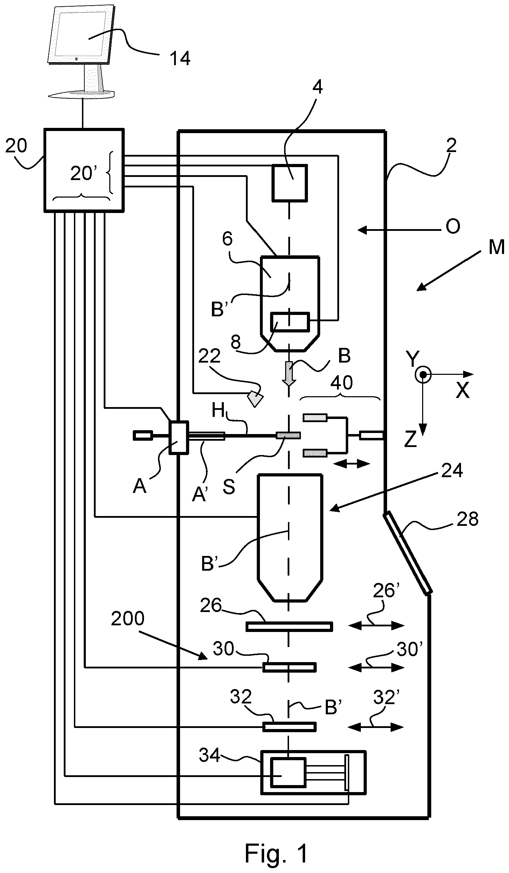

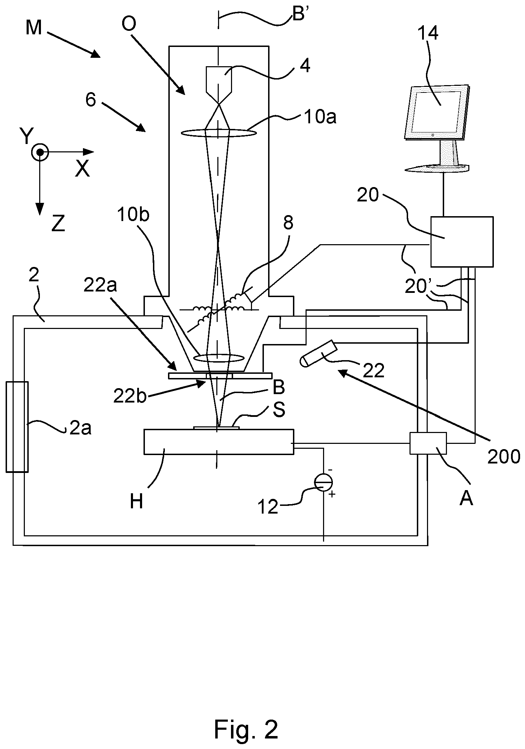

Fig. 1 (not to scale) is a highly schematic depiction of an embodiment of a charged-particle microscope M according to an embodiment of the invention. More specifically, it shows an embodiment of a transmission-type microscope M, which, in this case, is a TEM/STEM (though, in the context of the current invention, it could just as validly be a SEM (see Figure 2), or an ion-based microscope, for example). In Fig. 1, within a vacuum enclosure 2, an electron source 4 produces a beam B of electrons that propagates along an electron-optical axis B' and traverses an electron-optical illuminator 6, serving to direct/focus the electrons onto a chosen part of a sample S (which may, for example, be (locally) thinned/planarized). Also depicted is a deflector 8, which (*inter alia*) can be used to effect scanning motion of the beam B.

The sample S is held on a sample holder H that can be positioned in multiple degrees of freedom by a positioning device / stage A, which moves a cradle A' into which holder H is (removably) affixed; for example, the sample holder H may comprise a finger that can be moved (*inter alia*) in the XY plane (see the depicted Cartesian coordinate system; typically, motion parallel to Z and tilt about X/Y will also be possible). Such movement allows different parts of the sample S to be illuminated / imaged / inspected by the electron beam B traveling along axis B' (in the Z direction) (and/or allows scanning motion to be performed, as an alternative to beam scanning). If desired, an optional cooling device (not depicted) can be brought into intimate thermal contact with the sample holder H, so as to maintain it (and the sample S thereupon) at cryogenic temperatures, for example.

The electron beam B will interact with the sample S in such a manner as to cause various types of "stimulated" radiation to emanate from the sample S, including (for example) secondary electrons, backscattered electrons, X-rays and optical radiation (cathodoluminescence). If desired, one or more of these radiation types can be detected with the aid of analysis device 22, which might be a combined scintillator/photomultiplier or EDX (Energy-Dispersive X-Ray Spectroscopy) module, for instance; in such a case, an image could be constructed using basically the same principle as in a SEM. However, alternatively or supplementally, one can study electrons that traverse (pass through) the sample S, exit/emanate from it and continue to propagate (substantially, though generally with some deflection/scattering) along axis B'. Such a transmitted electron flux enters a projection system (projection lens 24), which will generally comprise a variety of electrostatic / magnetic lenses, deflectors, correctors (such as stigmators), *etc.* In normal (non-scanning) TEM mode, this projection system 24 can focus the transmitted electron flux onto a fluorescent screen 26, which, if desired, can be retracted/withdrawn (as schematically indicated by arrows 26') so as to get it out of the way of axis B'. An image (or diffractogram) of (part of) the sample S will be formed by projection system 24 on screen 26, and this may be viewed through viewing port 28 located in a suitable part of a wall of enclosure 2. The retraction mechanism for screen 26 may, for example, be mechanical and/or electrical in nature, and is not depicted here.

As an alternative to viewing an image on screen 26, one can instead make use of the fact that the depth of focus of the electron flux leaving projection system 24 is generally quite large (e.g. of the order of 1 meter). Consequently, various other types of analysis apparatus can be used downstream of screen 26, such as:
- TEM detector (camera) 30. At camera 30, the electron flux can form a static image (or diffractogram) that can be processed by controller/processor 20 and displayed on a display device (not depicted), such as a flat panel display, for example. When not required, camera 30 can be retracted/withdrawn (as schematically indicated by arrows 30') so as to get it out of the way of axis B'.
- STEM detector (camera) 32. An output from camera 32 can be recorded as a function of (X,Y) scanning position of the beam B on the sample S, and an image can be constructed that is a "map" of output from camera 32 as a function of X,Y. Camera 32 can comprise a single pixel with a diameter of e.g. 20 mm, as opposed to the matrix of pixels characteristically present in camera 30. Moreover, camera 32 will generally have a much higher acquisition rate (*e*.*g*. 10⁶ points per second) than camera 30 (*e*.*g*. 10² images per second). Once again, when not required, camera 32 can be retracted/withdrawn (as schematically indicated by arrows 32') so as to get it out of the way of axis B' (although such retraction would not be a necessity in the case of a donut-shaped annular dark field camera 32, for example; in such a camera, a central hole would allow flux passage when the camera was not in use).
- As an alternative to imaging using cameras 30 or 32, one can also invoke spectroscopic detector 34, which could be an EELS module, for example.

It should be noted that the order/location of items 30, 32 and 34 is not strict, and many possible variations are conceivable. For example, spectroscopic detector 34 can also be integrated into the projection system 24.

In the embodiment shown, the microscope M further comprises a retractable X-ray Computed Tomography (CT) module, generally indicated by reference 40. In Computed Tomography (also referred to as tomographic imaging) the source and (diametrically opposed) detector are used to look through the sample along different lines of sight, so as to acquire penetrative observations of the sample from a variety of perspectives.

Note that the detectors 30,32, 34 are part of an imaging system (generally indicated with reference sign 200). The imaging system is arranged for generating an image signal based on information from the charged particle detector 30, 32, 34, and can be part of that detector or be a separate part from that detector. The controller (computer processor) 20 is connected to various illustrated components *via* control lines (buses) 20'. This controller 20 can provide a variety of functions, such as synchronizing actions, providing setpoints, processing signals, performing calculations, and displaying messages/information on a display device (not depicted). Needless to say, the (schematically depicted) controller 20 may be (partially) inside or outside the enclosure 2, and may have a unitary or composite structure, as desired.

The skilled artisan will understand that the interior of the enclosure 2 does not have to be kept at a strict vacuum; for example, in a so-called "Environmental TEM/STEM", a background atmosphere of a given gas is deliberately introduced / maintained within the enclosure 2. The skilled artisan will also understand that, in practice, it may be advantageous to confine the volume of enclosure 2 so that, where possible, it essentially hugs the axis B', taking the form of a small tube (*e*.*g*. of the order of 1 cm in diameter) through which the employed electron beam passes, but widening out to accommodate structures such as the source 4, sample holder H, screen 26, camera 30, camera 32, spectroscopic detector 34, *etc.*

Now first referring to Fig. 2, another embodiment of an apparatus as disclosed herein is shown. Fig. 2 (not to scale) is a highly schematic depiction of a charged-particle microscope M; more specifically, it shows an embodiment of a non-transmission-type microscope M, which, in this case, is a SEM (though, in the context of the current invention, it could just as validly be an ion-based microscope, for example). In the Figure, parts which correspond to items in Figure 1 are indicated using identical reference symbols, and will not be separately discussed here. Additional to Figure 1 are (*inter alia*) the following parts:
- 2a: A vacuum port, which may be opened so as to introduce/remove items (components, samples) to/from the interior of vacuum chamber 2, or onto which, for example, an ancillary device/module may be mounted. The microscope M may comprise a plurality of such ports 2a, if desired;
- 10a, 10b: Schematically depicted lenses / optical elements in illuminator 6;
- 12: A voltage source, allowing the sample holder H, or at least the sample S, to be biased (floated) to an electrical potential with respect to ground, if desired;
- 14: A display, such as a FPD or CRT;
- 22a, 22b: A segmented electron detector 22a, comprising a plurality of independent detection segments (*e*.*g*. quadrants) disposed about a central aperture 22b (allowing passage of the beam B). Such a detector can, for example, be used to investigate (the angular dependence of) a flux of output (secondary or backscattered) electrons emerging from the sample S.

Thus, the charged particle microscopes M shown in Fig. 1 and 2 each comprise a charged particle optical column O for directing a charged particle beam B onto a sample; a sample holder H for holding a sample S; and a charged particle detector 22a, 22b, 30, 32, 34 with an imaging system 200 for generating an image signal based on information from the charged particle detector.

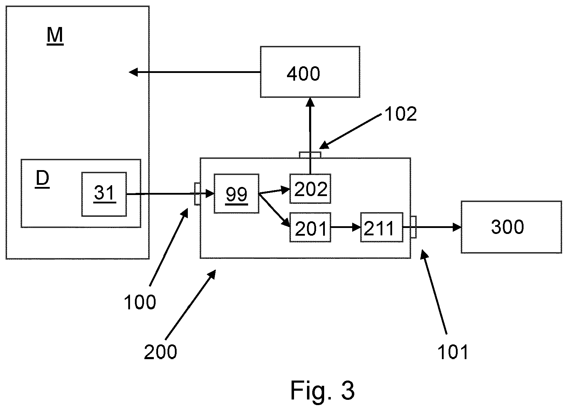

Now turning to Fig. 3, an embodiment of the charged particle microscope M including more details of the charged particle detector D and imaging system 200 as disclosed herein are shown. It is noted that generally, the detector D can be any one of TEM camera 30, STEM camera 32, spectroscopic detector 34 or segmented detector 22 as shown in Fig. 1 or 2, or any charged particle detector in general. Similar to Fig. 1 and Fig. 2, the charged particle microscope M comprises a detector D, which includes a detector chip 31. Raw data coming from that detector chip 31 is sent to an input interface 100 of imaging system 200. The imaging system 200 is arranged to generate an image signal based on information from the charged particle detector D.

In the embodiments described herein, the charged particle detector D a charged particle camera D that is arranged for acquiring images of a sample. It should be noted that the use of low latency and higher latency output interfaces is applicable, in general, to charged particle detectors as well. For reasons of conciseness, the term detector will therefore be used. It will be understood to those skilled in the art that the term detector here explicitly refers to both charged particle cameras (arranged for obtaining images) and other types of detectors (arranged for acquiring other data).

As shown in Fig. 3, said imaging system 200 generally comprises an input interface 100 for receiving data, and a first charged particle detector output interface 101 for outputting a first data stream of data related to said charged particle detector D, as well as a second charged particle detector output interface 102 for outputting a second data stream of data related to said charged particle detector D.

In Fig. 3, the first charged particle detector output interface 101 is arranged for transferring data to storage 300. The connection from detector D, via imaging system 200, to storage 300 is used for storing high quality images from the sample. Here, the set-up of the first data stream is such that data quality and reliability are prioritized, ensuring accurate and dependable data output to storage 300 (i.e. maintaining the high image quality standard that present day charged particle microscopes are known for).

As defined herein, the imaging system also comprises a second charged particle detector output interface 102. The second charged particle detector output interface 102 is arranged for providing a different output compared to the first output interface 101. In particular, the second charged particle detector output interface 102 is arranged for providing low latency output to feedback data processing device 400, which in turn is connected to microscope M. Hence, a feedback control loop is established which can be used for feedback control applications, such as active image-based drift compensation, continuous tilt tomography field-of-view correction, or system state measurement methods.

Imaging system 200 comprises, in the embodiment shown, a data processing unit 99 that is arranged for processing so called "raw" data coming from detector chip 31. It is noted that this processing unit 99 may be part of the detector D itself, and thus the imaging system 200 may comprise a part of the detector D too. Other arrangements are conceivable as well.

After the initial processing that is done by processing unit 99, the signal may be split into two different streams.

One stream is connected to the first charged particle detector output interface 101, and includes a storage representation module 201 and a buffer 211. The storage representation module 201 and the buffer 211 are arranged for providing high quality image data from the detector D to the storage 300, substantially without loss of any image information.

One other stream is connected to the second charged particle detector output interface 102 and includes low latency representation module 202. The low latency representation module 202 is arranged to process the signal coming from the detector D (and optionally processed by data processing unit 99), and provide them to second charged particle detector output interface 102. From there, they can be forwarded to feedback data processing device 400, where additional processing for enabling real-time feedback to charged particle microscope M may take place. This enables low-latency feedback to be provided to charged particle microscope M, which may include stage moves and/or optics changes.

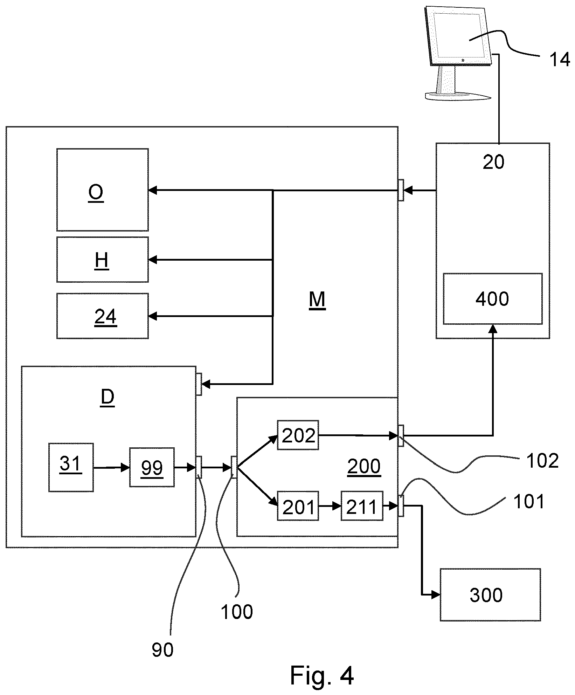

Fig. 4 shows a further embodiment of the charged particle microscope M with the imaging system 200 as disclosed herein. Here, the detector D comprises a camera chip 31 and a data processing unit 99. The data processing unit 99 is arranged for performing fast "essential" processing, which may include gain corrections and electron counting in case where the detector D is an electron detector. That processing will normally be done with a low latency. The resulting information is sent from detector D, through output 90 towards input interface 100 of imaging system 200. In imaging system 200, the data is split into two different representation blocks 201, 202. These 201, 202 may be arranged for converting the data into desired output-specific representation. These blocks 201, 202 may contain additional processing steps as well as data augmentation steps based on other information sources such as system clocks. For example, if the user chooses dose fraction storage, the storage representation block 201 will create dose fraction images, while the low-latency representation block 202 could output an Electron Event Representation stream (streams of electron event positions (x,y,time)), while embedding extra timing information such as synchronized time stamps. The storage representation 201 is buffered in block 211 to ensure no data is lost if e.g. the connection to the storage 300 gets shortly interrupted. The low-latency representation 202 is transmitted without buffering (or at least no large buffering) to prevent adding extra latency.

This low latency representation module 202 may, in an embodiment, run independently from the earlier mentioned storage representation module 201. The low latency representation module 202 is preferably optimized for low latency, while reliability of the data is a lower priority: this means that it is allowed to miss small portions of the data, as long as this is detectable.

A specific type of detector D of interest is an electron counting camera: in this case the electron counting algorithm is the key algorithm. The type of data on the output data interfaces 201 can be image "movies" (called dose fractions) or streams of electron event positions (x,y,time), which are also known as Electron Event Representation (EER). Providing EER data on the low latency output data interface 202 allows low latency event-based processing for low-dose applications. Under low-dose conditions, low-latency EER data will lead to the best possible performance in the use-cases mentioned above.

Turning back to Fig. 4, it is shown that the low latency representation module 202 may be connected to feedback data processing device 400, which, in the embodiment shown, is part of controller/processor 20. It will be clear to those skilled in the art that feedback data processing device 400 may be a separate controller/processor as well. From here, the controller/processor 20 is able to provide feedback to the charged particle microscopes M (as shown in Fig. 1 and 2, for example) by changing settings/parameters to one or more of the optical column O, the sample holder H, the imaging system 24 and/or charged particle detector D (which may be any one of 22a, 22b, 30, 32, 34 as shown in Fig. 1 and 2). Feedback data processing device 400, together with low latency representation module 202 thus allows real-time feedback to be supplied to the charged particle microscope M.

In summary, a charged particle microscope M is described that incorporates dual data stream output interfaces 101, 102 within its imaging system 200. These interfaces enable the microscope M to capture and process data from the charged particle detector D in two distinct ways, leading to enhanced imaging capabilities and improved flexibility. This is in particular true in case one data stream is aimed at low latency 102, which enables real-time feedback to the microscope M.

## Claims

1. A charged particle microscope, comprising:
- a charged particle optical column for directing a charged particle beam onto a sample;
- a sample holder for holding a sample; and
- a charged particle camera, and an imaging system for generating an image signal based on information from the charged particle camera;
wherein said imaging system comprises a first charged particle camera output interface for outputting a first data stream of data related to said charged particle camera;
**characterized in that** said imaging system further comprises a second charged particle camera output interface for outputting a second data stream of data related to said charged particle camera, wherein said second data stream is arranged to be different compared to said first data stream.

2. The charged particle microscope of claim 1, wherein the second data stream is optimized for low latency output.

3. The charged particle microscope of claim 1 or 2, wherein the second data stream is arranged to have a maximum low latency output of 750 ms, in particular of 250 ms, or less.

4. The charged particle microscope of claim 3, wherein the second data stream is arranged to have a substantially fixed low latency output.

5. The charged particle microscope of claim 3 or 4, wherein the second data stream is arranged to have an average latency output that is below 100 ms.

6. The charged particle microscope according to claim 1-5, wherein the charged particle microscope and the second charged particle camera output data interface are connected and arranged for using the image signal from the imaging system for providing real-time feedback to the charged particle microscope.

7. The charged particle microscope of claim 1-6, wherein the first data stream is optimized for high reliability.

8. The charged particle microscope of claim 7, wherein the first data stream is optimized for complete data transfer without data loss.

9. The charged particle microscope of claims 1-8, wherein the second charged particle camera output interface operates independently of the first charged particle camera output interface.

10. The charged particle microscope of claims 1-9, wherein the system comprises a data processing unit upstream of said first and second charged particle camera output interfaces, and wherein said data processing unit is arranged for processing data that is provided to said second charged particle camera output interface.

11. The charged particle microscope of claim 10, wherein said charged particle camera includes said data processing unit.

12. The charged particle microscope of claims 1-11, wherein the charged particle microscope comprises a feedback data processing device downstream of said second charged particle camera output interface.

13. Method of operating a charged particle microscope of claim 1-12, comprising the steps of using said second charged particle camera output interface for providing low latency data.

14. Method according to claim 13, comprising the step of using said low latency data for controlling operations of said charged particle microscope.
